**Europäisches Patentamt**

**European Patent Office**

**Office européen des brevets**

(19)

(11) Veröffentlichungsnummer: **0 101 762**
**B1**

(12) # EUROPÄISCHE PATENTSCHRIFT

(45) Veröffentlichungstag der Patentschrift:
**06.04.87**

(51) Int. Cl.⁴: **H 01 L 21/24**

(21) Anmeldenummer: **82201054.2**

(22) Anmeldetag: **24.08.82**

(54) **Verfahren zur Thermomigration flüssiger Phasen und Vorrichtung zur Durchführung des Verfahrens.**

(43) Veröffentlichungstag der Anmeldung:
**07.03.84 Patentblatt 84/10**

(45) Bekanntmachung des Hinweises auf die Patenterteilung:
**06.04.87 Patentblatt 87/15**

(84) Benannte Vertragsstaaten:
**CH DE FR GB LI**

(56) Entgegenhaltungen:
**US-A-3 977 910**
**US-A-3 988 763**
**US-A-3 990 093**

(73) Patentinhaber: **BBC Aktiengesellschaft Brown, Boveri & Cie., Haselstrasse, CH- 5401 Baden (CH)**

(72) Erfinder: **Kluge- Weiss, Petra, Dr., Badenerstrasse 151, CH- 5413 Birmenstorf AG (CH)**

LIBER, STOCKHOLM 1987

EP 0 101 762 B1

## Beschreibung

Die Erfindung betrifft ein Verfahren zur Thermomigration flüssiger Phasen gemäss dem Oberbegriff des Anspruchs 1 sowie eine Vorrichtung zur Durchführung des Verfahrens.

Ein solches Verfahren ist aus der Druckschrift US-PS 3 977 910 bekannt. Ausgehend von einem Halbleitersubstrat mit wenigstens einer ebenen Oberfläche, werden auf dieser Oberfläche mit Hilfe eines photolithographischen Ätzprozesses Vertiefungsmuster erzeugt und in einem nachfolgenden Aufdampfprozess mit einem geeigneten Metall aufgefüllt. Das in dieser Weise präparierte Substrat wird unter einer Schutzgasatmosphäre aus einem gut wärmeleitenden Gas in einem Temperaturgradienten so weit erhitzt, dass das abgeschiedene Metall unter gleichzeitigem Anlösen des Halbleitermaterials eine Schmelzzone mit flüssiger Phase bildet, die in der dem anliegenden Temperaturgradienten entgegengesetzten Richtung durch das Halbleitersubstrat wandert und als Spur eine feste Legierungszone hinterlässt, die gleichzeitig als Dotierungszone im Halbleiter anzusehen ist.

Die Schmelzzone kann entweder durch das Substrat vollständig hindurchwandern und so eine durchgehende Dotierungszone erzeugen, oder in einer endlichen Tiefe durch Umkehrung des Temperaturgradienten zur Richtungsumkehr gezwungen werden, so dass sich eine Dotierungszone im Halbleitersubstrat bildet, die bis in eine endliche Tiefe reicht.

Die Umkehrung des Temperaturgradienten relativ zum Substrat kann prinzipiell dadurch bewirkt werden, dass entweder die Lage des Substrats geändert, das Substrat also z.B. im Gradienten umgedreht wird, oder dass der Gradient selbst seine Richtung wechselt. Die zweite Möglichkeit vermeidet mechanische Mittel zum Manipulieren der Substratlage, wenn der Gradient durch ein Paar von gegenüberliegenden Widerstandsheizern aus Wolfram erzeugt und auf elektrischem Wege über die Heizleistungen der einzelnen Widerstandsheizer beeinflusst wird.

Die Realisierung einer elektrisch gesteuerten Gradientenumkehr nach dem bekannten Verfahren wirft jedoch Probleme auf, da in der während des gesamten Migrationsvorganges verwendeten Gasatmosphäre durch Wärmekonvektion einerseits Instabilitäten in Form von zusätzlichen, radialen Temperaturgradienten auftreten und andererseits die beiden Gradientenrichtungen nicht gleichwertig sind, weil sich die Konvektion im einen Fall additiv, im anderen Fall jedoch subtraktiv dem Gradienten überlagert.

Weiterhin sind bei dem beschriebenen Verfahren vor der Migration mehrere Prozeßschritte notwendig, um das Metall in den Vertiefungen des Substrats abzulagern, weil die Gleichmässigkeit der Temperaturverteilung, wie sie von den Widerstandsheizern aus Wolframdraht erzeugt wird, nicht ausreicht um eine einwandfreie Migration von der Substratoberfläche her zu gewährleisten und insbesondere die Schmelze auf der Oberfläche nicht stabil ist und zur Tropfenbildung neigt.

Darüber hinaus besteht die Gefahr, dass bei der Umkehrung des Temperaturgradienten die Schmelzzone im Halbleitersubstrat zeitweise erstarrt und zu Verspannungen und damit möglicherweise zu mechanischen Schäden im Substrat führt.

Der vorliegenden Erfindung liegt daher die Aufgabe zugrunde, ein Verfahren zur Thermomigration zu schaffen, das bei gleichzeitiger Verringerung der Anzahl der notwendigen Verfahrensschritte eine Verbesserung in der Qualität der mit dem Verfahren hergestellten Dotierungsstrukturen erbringt.

Die Aufgabe wird bei einem gattungsgemässen Verfahren dadurch gelöst, dass die Merkmale aus dem Kennzeichen des Anspruchs 1 vorgesehen sind. Bei einem bevorzugten Ausführungsbeispiel des erfindungsgemässen Verfahrens wird die Metallschicht durch einen Aufdampfprozess mit nachfolgender photolithographischer Strukturierung erzeugt. Bei der erfindungsgemässen Vorrichtung zur Durchführung des Verfahrens bestehen die Widerstandsheizer aus pyrolysiertem Elektrographit, wobei vorzugsweise die heizbaren Flächen mit Oberflächen der Widerstandsheizer identisch sind.

Das erfindungsgemässe Verfahren sowie die Vorrichtung zur Durchführung des Verfahrens werden nachfolgend anhand in der Zeichnung dargestellter Ausführungsbeispiele beschrieben und erläutert. Es zeigen:

Fig. 1 ein für die Migration vorbereitetes Substrat mit aufgebrachter Metallschicht.

Fig. 2 ein Substrat während des Migrationsprozesses im Temperaturgradienten

Fig. 3 ein nach dem erfindungsgemässen Verfahren hergestelltes Substrat mit Dotierungsstruktur

Fig. 4 ein Ausführungsbeispiel der Vorrichtung zur Durchführung des erfindungsgemässen Verfahrens.

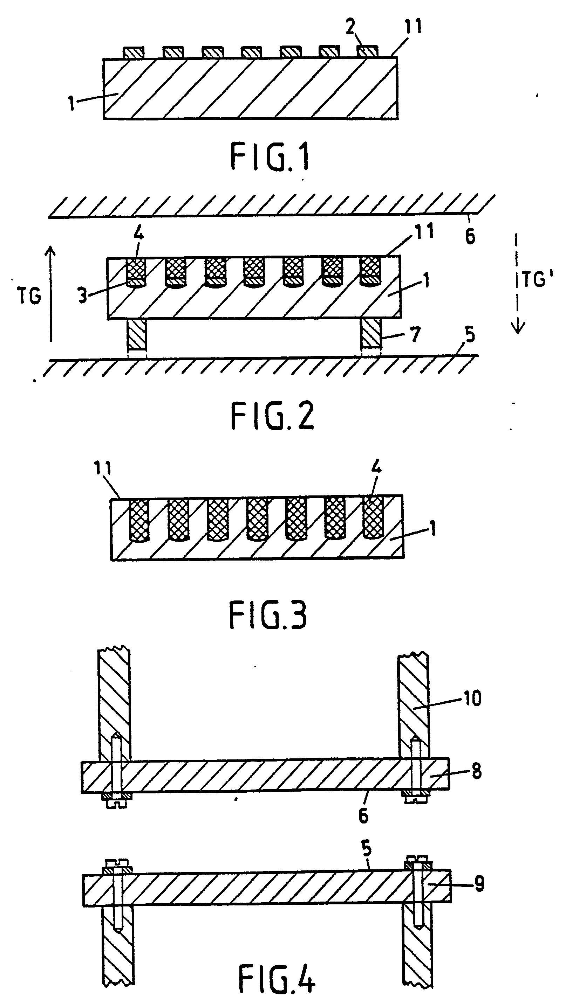

Bei dem Verfahren zur Thermomigration wird von einem Halbleitersubstrat ausgegangen, das beispielsweise aus Silizium besteht und üblicherweise einkristallin mit einer bevorzugten Orientierung der Kirstallachsen ist. Für die Herstellung von Dioden mit tiefen P-N-Übergängen wird vorteilhafterweise ein bereits dotiertes Halbleitermaterial von einem Leitfähigkeitstyp und einem definierten, spezifischen Widerstand verwendet. Das Substrat hat in den meisten Fällen die Form einer flachen, von einem Zylinder abgesägten Scheibe. Die Oberflächen werden vor der Migration nach bekannten Methoden geschliffen, poliert und gereinigt. Wie in Fig. 1 im Ergebnis dargestellt, wird auf eine so vorbehandelte, ebene Oberfläche 11 des Halbleitersubstrats 1 eine Metallschicht 2 aufgebracht. Handelt es sich beim Substratmaterial um N-dotiertes Silizium, kann die Metallschicht 2 beispielsweise aus Aluminium bestehen.

Das beschichtete Halbleitersubstrat wird gemäss Fig. 2 in einer Vakuumapparatur in einen Temperaturgradienten TG gebracht, der durch zwei parallel angeordnete, gleichmässig heizbare Flächen 5 und 6 erzeugt wird, die sich auf unterschiedlichen Temperaturen befinden. Die in Fig. 2 durch den Pfeil angedeutete Richtung des Temperaturgradienten TG wird dadurch erreicht, dass die Temperatur der unteren Fläche 5 höher ist, als die Temperatur der oberen Fläche 6. Entsprechend umgekehrte Verhältnisse ergeben sich für die gestrichelt eingezeichnete Richtung des Temperaturgradienten TG'.

Zunächst wird das Halbleitersubstrat 1 in einer Schutzgasatmosphäre aufgeheizt, um die Oberflächenspannung der sich bildenden Schmelze zu verringern und so eine Tropfenbildung zu vermeiden. Die Schutzgasatmosphäre besteht vorteilhafterweise aus N₂ mit einem Druck von 532 bis 798 hPa (400-600 Torr). Kurz nach Erreichen der Migrationstemperatur und bei Beginn der Migration wird die N₂-Atmosphäre dann abgepumpt.

Da die Anordnung gemäss Fig. 2 während der Migration unter Vakuumbedingungen betrieben wird, findet ein Austausch von Wärmeenergie zwischen den Flächen 5 und 6, und dem Halbleitersubstrat 1 ausschliesslich über Wärmestrahlung statt. Aufgrund dieses Strahlungsaustausches stellt sich im Halbleitersubstrat ein Temperaturgradient ein, der von den Temperaturen der Flächen 5 und 6 sowie von den Emissions- und Absorptionscharakteristiken aller am Strahlungsaustausch beteiligten Flächen abhängt. Dadurch ergibt sich eine ausserordentlich gleichmässige Temperaturverteilung, die weder durch Konvektionserscheinungen, noch durch unzureichenden Wärmeübergang zwischen zwei Körpern beeinträchtigt wird.

Der Bereich der im Halbleitersubstrat 1 auftretenden Temperaturen wird so gewählt, dass er unterhalb der Schmelztemperatur des verwendeten Halbleitermaterials, jedoch oberhalb des niedrigeren Schmelzpunktes des aufgebrachten Metalls liegt. Im Falle des Silizium-Aluminium-Systems mit Schmelztemperaturen von 1417°C und 658°C wird das Substrat beispielsweise auf eine mittlere Temperatur von 1200°C gebracht, wobei der Temperaturgradient TG zwischen 50°C/cm und 200°C/cm betragen kann.

Sobald beim Erwärmungsvorgang die Schmelztemperatur des Metalls in der Metallschicht 2 erreicht wird, bildet sich eine Schmelzzone 3, die an der Berührungsfläche 11 mit dem Substrat Halbleitermaterial anlöst und auf diese Weise eine flüssige Metall-Halbleiterlegierung erzeugt. Die Schmelzzone 3 wandert in bekannter Weise entgegen der Richtung des anliegenden Temperaturgradienten TG und hinterlässt als Spur dieser Migration eine feste Legierungszone 4.

Wenn die Schmelzzone 3 im Halbleitersubstrat 1 eine vorbestimmte Tiefe erreicht hat, die sich unter anderem nach der Grösse des herrschenden Temperaturgradienten und der Dauer des Migrationsvorganges richtet, wird die Richtung des Temperaturgradienten durch entsprechende Regelung der Temperaturen auf den Flächen 5 und 6 umgekehrt, so dass sich ein neuer Gradient TG' einstellt.

Dabei werden gleichzeitig die Temperatur der wärmeren Fläche 5 erniedrigt und die Temperatur der kälteren Fläche 6 erhöht. Daraus ergibt sich der Vorteil, dass die mittlere Temperatur im Substrat während des Umkehrungsvorganges ausreichend hoch gehalten werden kann, um ein zeitweises Erstarren der Schmelzzone 3 und die damit verbundenen thermomechanischen Spannungen im Halbleiterkristall zuverlässig zu verhindern.

Durch die besondere Art der Prozessführung, die Verringerung der Oberflächenspannung beim Aufheizen in einer Schutzgasatmosphäre und die Gleichmässigkeit der Temperaturverteilung bei der Migration im Vakuum, d.h. die Richtungskonstanz des Temperaturgradienten, wie er durch die parallel angeordneten, gleichmässig heizbaren Flächen 5 und 6 erzeugt wird, erübrigen sich Verfahrensschritte, die beispielsweise durch Anätzen der Substratoberfläche partielle Vertiefungen erzeugen, in die das Metall eingebracht und so bei der Migration bereits eine Vorzugsrichtung vorgegeben wird. Daher wird die Metallschicht 2 direkt auf eine ebene, unstrukturierte Oberfläche aufgebracht.

Gemäss einer Ausgestaltung des Verfahrens werden nach Beendigung der Migration, wenn die Schmelzzone 3 aufgrund des umgekehrten Temperaturgradienten aus dem Inneren des Halbleitersubstrats 1 wieder zur Substratoberfläche 11 gewandert ist, Rückstände des Metalls bei erhöhter Temperatur, also aus der flüssigen Phase, von der Substratoberfläche abgedampft. Dies hat gegenüber dem Stand der Technik den besonderen Vorteil, dass der übliche Abtrageprozess, bei dem nach Beendigung der Migration eine Oberflächenschicht bestimmter Dicke, welche die erstarrte, metallreiche Phase der ursprünglichen Schmelzzone enthält, mechanisch oder chemisch abgetragen wird, entfallen kann.

Gemäss einer weiteren Ausgestaltung des Verfahrens nach der vorliegenden Erfindung wird die Metallschicht 2 mit Hilfe eines bekannten Aufdampfprozesses mit nachfolgender photolithographischer Strukturierung erzeugt. So sind mit Erfolg für die Migration aufgedampfte Linien aus Aluminium von 40 μm Breite und 1,4 mm Länge verwendet worden, die insbesondere eine Schichtdicke von 3 μm aufweisen.

Besonders vorteilhaft ist es, während der Migration in der eingesetzten Apparatur ein Vakuum besser als 1.33 mPa (1 x 10⁻⁵ Torr) aufrechtzuerhalten, weil dadurch gewährleistet wird, dass einerseits die Ausbildung der Temperaturgradienten TG und TG' nicht durch Konvektionserscheinungen beeinflusst wird und andererseits die Verunreinigung des Substrats durch Fremdatome gering bleibt.

Neben den bereits erwähnten Konvektionserscheinungen kann darüber hinaus die Gleichmässigkeit der Temperaturverteilung durch unkontrollierte Wärmeleitung über Berührungsflächen zwischen dem Substrat 11 und den heizbaren Flächen 5 und 6 beeinträchtigt werden. Daher ist es vorteilhaft, dass ein Wärmetransport zwischen dem Halbleitersubstrat und den Flächen ausschliesslich durch Strahlung erfolgt.

Insbesondere hat es sich als günstig erwiesen, zwischen dem Halbleitersubstrat 11 und den heizbaren Flächen 5 und 6 durch Abstandshalter 7 aus Quarz einen Abstand von 5-15 mm einzuhalten, um hinsichtlich des Strahlungsaustausches geeignete geometrische Verhältnisse zu erhalten. Zur Vermeidung einer direkten Wärmeleitung sind die Abstandshalter 7 vorteilhafterweise so ausgebildet, dass sie die heizbare Fläche 5 nicht berühren. Entsprechend sollten zur Vermeidung von Randeffekten die heizbaren Flächen erheblich grösser sein, als die gegenüberliegenden Oberflächen des Halbleitersubstrats. So können bei heizbaren Flächen von 70 x 70 mm² in einem Gebiet von 30 x 30 mm² homogene Temperaturverhältnisse erwartet werden.

Eine für die Migration geeignete, mittlere Substrattemperatur wird dadurch erreicht, dass die Temperatur der jeweils wärmeren Fläche, also beim Temperaturgradienten TG die Temperatur der Fläche 5, während der Migration auf etwa 1540° C gehalten wird. Die Grösse des Gradienten lässt sich dann über die Temperatur der anderen Fläche einstellen. Insgesamt können mit Hilfe beider Flächen sowohl die mittlere Substrattemperatur, als auch der Gradient unabhängig voneinander eingeregelt werden.

Um für die Regelung der heizbaren Flächen einen geeigneten Istwert als Ausgangspunkt zu erhalten, ist es weiterhin vorteilhaft die Temperatur pyrometrisch mit einer Photodiode zu messen und zu überwachen, die auf Strahlung in einem Wellenlängenbereich von 0,7 bis 1,1 μm anspricht. Daraus ergibt sich insbesondere, dass die Temperaturmessung schnell und berührungslos erfolgt und die Strahlungsverhältnisse in der Migrationsapparatur berücksichtig werden.

Bei der Umkehrung des Temperaturgradienten TG in den Gradienten TG' wird eine Erstarrung der Schmelzzone 3 durch ein gleichzeitiges Erhöhen und Absenken der Temperaturen der kälteren bzw. wärmeren, heizbaren Fläche vermieden. Besonders zuverlässig wird die Erstarrung verhindert, wenn die niedrigere der Temperaturen der beiden heizbaren Flächen 5 und 6 bei der Umkehrung des Temperaturgradienten zu jeder Zeit oberhalb der Erstarrungstemperatur der flüssigen Phase in der Schmelzzone 3 gehalten wird.

Ein nach dem erfindungsgemässen Verfahren hergestelltes Halbleitersubstrat mit einer aus Legierungszonen 4 bestehenden Dotierungsstruktur ist in Fig. 3 dargestellt.

Fig. 4 zeigt eine Vorrichtung zur Durchführung des Verfahrens, bei der die Widerstandsheizer 8 und 9, die zur Erwärmung der heizbaren Flächen 5 und 6 dienen, aus pyrolysiertem Elektrographit bestehen und daher bei einem günstigen, elektrischen Widerstand und grosser Temperaturbeständigkeit auch eine gleichmässig gute Strahlungsabgabe aufweisen. Die Widerstandsheizer sind beispielsweise als Platten mit einer Dicke von etwa 6 mm ausgeführt und über Stromzuführungen 10, die aus elektrischen und thermischen Gründen aus Kupfer bestehen, an eine leistungsfähige und regelbare Stromquelle angeschlossen.

Gemäss einer besonders einfachen Ausführungsform der Vorrichtung sind die heizbaren Flächen 5 und 6 direkt mit entsprechenden Oberflächen der Widerstandsheizer 8 und 9 identisch.

Bei einer weiteren Ausführungsform sind die Platten der Widerstandsheizer 8 und 9 zur Erhöhung des elektrischen Widerstandes geschlitzt. Wenn diese Schlitze bei einer Breite von etwa 2 mm in einem Abstand von 10 mm angeordnet sind, ergeben sich nach den durchgeführten Untersuchungen bei einem ausreichenden Abstand zwischen Substrat und Heizer von etwa 15 mm keine nachteiligen Einflüsse auf die Gleichmässigkeit der Temperaturverteilung.

Andererseits können die Widerstandsheizer 8 und 9 aus einer Graphitfolie von etwa 0,2 mm Dicke bestehen, auf das eine Graphitplatte zur Homogenisierung des Strahlungsfeldes aufgelegt ist, so dass die Heizer und die heizbaren Flächen als getrennte Teile ausgeführt sind und unabhängig voneinander optimiert werden können.

Insgesamt zeichnet sich das erfindungsgemässe Verfahren bei gleichzeitig guten Ergebnissen für die hergestellten Dotierungsstrukturen durch die grosse Einfachheit und Zuverlässigkeit aus und kann daher insbesondere bei der Serienfertigung von Halbleiterelementen, deren Funktion und Betriebsverhalten auf der Anwesenheit von "tiefen" P-N-Übergängen beruht, mit grosser Wirtschaftlichkeit eingesetzt werden. Als Beispiel seien solche Halbleiterelemente genannt, die unter dem Namen "Gridistoren" bekannt sind.

**Patentansprüche**

1. Verfahren zur Thermomigration flüssiger Phasen, bei dem eine Metallschicht (2) mit einem Halbleitersubstrat (1) in Kontakt gebracht, bei einer erhöhten Temperatur aus dem Material des Halbleitersubstrats (1) und dem Metall in einer Schutzgasatmosphäre eine Schmelzzone (3) mit flüssiger Phase erzeugt, die Schmelzzone (3) durch Migration in einem Temperaturgradienten (TG) zwischen zwei Widerstandsheizern (8, 9) von einer Substratoberfläche (11) bis zu einer endlichen Tiefe in das Innere des Halbleitersubstrats (1) bewegt und in einem umgekehrten Temperaturgradienten (TG') wieder an die Substratoberfläche (11) zurückgeführt werden, dadurch gekennzeichnet, dass die Metallschicht (2) auf eine ebene Substratoberfläche (11) aufgebracht, die Schutzgasatmosphäre zu Beginn der Migration abgepumpt wird, die Temperaturgradienten (TG, TG') im Vakuum durch zwei parallel angeordnete, gleichmässig heizbare Flächen (5, 6) mit unterschiedlicher Temperatur erzeugt, und zur Umkehrung des Temperaturgradienten gleichzeitig die Temperatur der wärmeren Fläche erniedrigt und die Temperatur der kälteren Fläche erhöht werden.

2. Verfahren nach Anspruch 1, dadurch gekennzeichnet, dass nach Beendigung der Migration Rückstände des Metalls bei erhöhter Temperatur von der Substratoberfläche (11) abgedampft werden.

3. Verfahren nach Anspruch 1, dadurch gekennzeichnet, dass die Metallschicht (2) durch einen Aufdampfprozess mit nachfolgender photolithographischer Strukturierung bis zu einer Dicke von 3 μm aufgedampft wird.

4. Verfahren nach Anspruch 1, dadurch gekennzeichnet, dass als Schutzgasatmosphäre N₂ mit einem Druck von 400-600 Torr verwendet und während der Migration ein Vakuum besser als 1.33 mPa (1 x 10⁻⁵ Torr) aufrechterhalten wird, und ein Wärmetransport zwischen dem Halbleitersubstrat (1) und den heizbaren Flächen (5, 6) ausschliesslich durch Strahlung erfolgt.

5. Verfahren nach Anspruch 4, dadurch gekennzeichnet, dass während der Migration zwischen dem Halbleitersubstrat (1) und den heizbaren Flächen (5, 6) ein Abstand von 5-15 mm durch Abstandshalter (7) aus Quarz eingehalten wird.

6. Verfahren nach Anspruch 1, dadurch gekennzeichnet, dass die Temperatur pyrometrisch mit einer Photodiode gemessen und überwacht wird, und die Temperatur der jeweils wärmeren Fläche (5, 6) während der Migration auf etwa 1540°C gehalten wird.

7. Verfahren nach Anspruch 1, dadurch gekennzeichnet, dass die niedrigere der Temperaturen der heizbaren Flächen (5, 6) bei der Umkehrung des Temperaturgradienten oberhalb der Erstarrungstemperatur der flüssigen Phase in der Schmelzzone (3) gehalten wird.

8. Vorrichtung zur Durchführung des Verfahrens nach Anspruch 1, dadurch gekennzeichnet, dass die Widerstandsheizer (8, 9) aus pyrolysiertem Elektrographit bestehen, und als Platten mit einer Dicke von etwa 6 mm ausgeführt und über Stromzuführungen (10) aus Kupfer angeschlossen sind.

9. Vorrichtung nach Anspruch 8 dadurch gekennzeichnet, dass die heizbaren Flächen (5, 6) Oberflächen der Widerstandsheizer (8, 9) sind, und dass die Platten der Widerstandsheizer (8, 9) zur Erhöhung des Widerstandes geschlitzt sind.

10. Vorrichtung nach Anspruch 8, dadurch gekennzeichnet, dass die Widerstandsheizer (8, 9) aus einer Graphitfolie mit 0,2 mm Dicke mit einer aufgelegten Graphitplatte bestehen.

## Claims

1 Method for achieving the thermal migration of liquid phases in which a metal layer (2) is brought into contact with a semiconductor substrate (1), a molten zone (3) with a liquid phase is produced at an elevated temperature from the material of the semiconductor substrate (1) and the metal in a protective gas atmosphere, and the molten zone (3) is moved by migration in a temperature gradient (TG) between two resistance heaters (8, 9) from one substrate surface (11) down to a final depth in the interior of the semiconductor substrate (1) and is brought back again to the substrate surface (11) in a reversed temperature gradient (TG'), characterized in that the metal layer (2) is deposited on a flat substrate surface (11), the protective gas atmosphere is pumped out at the beginning of the migration, the temperature gradients (TG, TG') are produced in vacuo by two uniformly heatable surfaces (5, 6), arranged in parallel, at different temperatures, and, to reverse the temperature gradient, the temperature of the hotter surface is lowered and the temperature of the colder surface is increased simultaneously.

2. Method according to Claim 1, characterized in that, after termination of the migration, residues of the metal are evaporated off the substrate surface (11) at elevated temperature.

3. Method according to Claim 1, characterized in that the metal layer (2) is vapour-deposited to a depth of 3 μm by a vapour-deposition process with subsequent photolithographic patterning.

4. Method according to Claim 1, characterized in that N₂ at a pressure of 532 to 798 hPA (460-600 torr) is used as protective gas atmosphere and a vacuum of better than 1.33 mPa (1 x 10⁻⁵ torr) is maintained during the migration, and heat transport between the semiconductor substrate (1) and the heatable surfaces (5, 6) takes place exclusively by radiation.

5. Method according to Claim 4, characterized in that, during the migration, a gap of 5-15 mm is maintained by quartz spacers (7) between the semiconductor substrate (1) and the heatable surfaces (5, 6).

6. Method according to Claim 1, characterized in that the temperature is measured and monitored pyrometrically with a photodiode, and the temperature of the surface (5, 6) which is hotter at any one time is held at about 1540° C during the migration.

7. Method according to Claim 1, characterized in that the lower of the temperatures of the heatable surfaces (5, 6) is held above the solidification temperature of the liquid phase in the molten zone (3) during the reversal of the temperature gradient.

8. Device for carrying out the method according to Claim 1, characterized in that the resistance heaters (8, 9) consist of pyrolyzed synthetic graphite, and are constructed as plates with a thickness of about 6 mm and are connected by means of copper current-supply conductors (10).

9. Device according to Claim 8, characterized in that the heatable surfaces (5, 6) are the surfaces of the resistance heaters (8, 9) and that the plates of the resistance heaters (8, 9) are slotted to increase the resistance.

10. Device according to Claim 8, characterized in that the resistance heaters (8, 9) consist of a graphite film having a thickness of 0.2 mm with a graphite plate laid thereon.

## Revendications

1. Procédé pour la thermomigration de phases liquides, dans lequel une couche de métal (2) est mise en contact avec un substcat semiconducteur (1), une zone de fusion (3) avec une phase liquide est produite à haute température et sous une atmosphère de gaz protecteur, à partir du matériau du substrat semi-conducteur (1) et du métal, la zone de fusion (3) est déplacée par migration dans un gradient de température (TG) entre deux résistances chauffantes (8, 9), depuis une surface (11) du substrat jusqu'à une profondeur finale à l'intérieur du substrat semi-conducteur (1) et est ramenée en arrière jusqu'à la surface (11) du substcat dans un gradient de température inversé (TG'), caractérisé en ce que la couche de métal (2) est déposée sur une surface plane (11) du substrat, en ce que l'atmosphère de gaz protecteur est évacuée par pompage au début de la migration, en ce que les gradients de température (TG, TG') sont produits sous vide par deux faces (5, 6) chauffables uniformément, disposées parallèlement, portées à des températures différentes, et en ce que, pour inverser le gradient de température, on abaisse la température de la face chaude tout en augmentant la température de la face froide.

2. Procédé suivant la revendication 1, caractérisé en ce que, lorsque la migration est terminée, les résidus du métal sont éliminés de la surface (11) du substrat par vaporisation à haute température.

3. Procédé suivant la revendication 1, caractérisé en ce que la couche de métal (2) est déposée par une opération de dépôt de vapeur suivie d'une structuration photolithographique, jusqu'à une épaisseur de 3 μm.

4. Procédé suivant la revendication 1, caractérisé en ce que, en guise d'atmosphère de gaz protecteur, on utilise $N_2$ sous une pression de 532 à 798 hPa (400-600 Torr), en ce que l'on maintient pendant la mmigration un vide de 1,33 mPa ($1.10^{-5}$ Torr), et en ce qu'il se produit un transfert de chaleur exclusivement par rayonnement entre le substrat semi-conducteur (1) et les faces de chauffage (5, 6).

5. Procédé suivant la revendication 4, caractérisé en ce que, pendant la migration, on maintient une distance de 5-15 mm entre le substrat semi-conducteur (1) et les faces de chauffage (5, 6) au moyen de pièces d'écartement (7) en quartz.

6. Procédé suivant la revendication 1, caractérisé en ce que la température est mesurée et surveillée par voie pyrométrique au moyen d'une photodiode, et en ce que la température de la face chaude (5, 6) est maintenue à environ 1540° C pendant la migration.

7. Procédé suivant la revendication 1, caractérisé en ce que la plus basse des températures des faces de chauffage (5, 6) est, pendant l'inversion du gradient de température, maintenue au-dessus de la température de solidification de la phase liquide dans la zone de fusion (3).

8. Dispositif pour la mise en oeuvre du procédé suivant la revendication 1, caractérisé en ce que les résistances chauffantes (8, 9) sont constituées d'électrographite pyrolysé, et en ce qu'elles sont réalisées sous forme de plaques d'une épaisseur d'environ 6 mm et raccordées par l'intermédiaire de conducteurs d'alimentation électrique (10) en cuivre.

9. Dispositif suivant la revendication 8, caractérisé en ce que les faces de chauffage (5, 6) sont les faces des résistances de chauffage (8, 9) et en ce que les plaques des résistances chauffantes (8, 9) sont fendues pour augmenter leur résistance électrique.

10. Dispositif suivant la revendication 8, caractérisé en ce que les résistances chauffantes (8, 9) se composent d'une feuille de graphite de 0,2 mm d'épaisseur sur laquelle est posée une plaque de graphite.

FIG.1

FIG.2

FIG.3

FIG.4